**Europäisches Patentamt**

**European Patent Office**

**Office européen des brevets**

(19)

(11) Veröffentlichungsnummer : **0 170 043**
**B1**

(12) **EUROPÄISCHE PATENTSCHRIFT**

(45) Veröffentlichungstag der Patentschrift :
01.02.89

(51) Int. Cl.⁴ : **H 05 K 13/00**

(21) Anmeldenummer : **85107777.6**

(22) Anmeldetag : **24.06.85**

(54) **Führungsvorrichtung für Halbleiterbauelemente mit DIL-Gehäusen.**

(30) Priorität : **29.06.84 DE 3424048**

(43) Veröffentlichungstag der Anmeldung :
**05.02.86 Patentblatt 86/06.**

(45) Bekanntmachung des Hinweises auf die Patenterteilung : **01.02.89 Patentblatt 89/05**

(84) Benannte Vertragsstaaten :
**AT DE FR GB IT NL**

(56) Entgegenhaltungen :
**EP--A-- 0 101 058**
**WO--A--79 /011 23**
**FR--A-- 2 468 284**

(73) Patentinhaber : **Siemens Aktiengesellschaft Berlin und München**
**Wittelsbacherplatz 2**
**D-8000 München 2 (DE)**

(72) Erfinder : **Walther, Albert, Dipl.-Ing. (FH)**
**Ignaz-Günther-Strasse 6**
**D-8150 Holzkirchen (DE)**

EP 0 170 043 B1

**Beschreibung**

Die Erfindung betrifft eine Führungsvorrichtung für Halbleiterbauelemente mit DIL-Gehäusen, bei welcher Vorkehrungen zum Schutz vor elektrostatischen Auf- und entladungen getroffen sind.

Bekanntlich ist eine elektrostatische Auf- bzw. Entladung häufig der Grund für eine Schädigung oder Zerstörung eines Halbleiterbauelementes. Elektrostatisch gefährdete Bauelemente müssen daher beim Transport, bei ihrer Aufbewahrung und in den Führungen von Maschinen, beispielsweise Automaten zur Abfüllung in Magazinstangen, in Bestückungsautomaten oder in Bestempelungsmaschinen, vor Ladungsschäden geschützt werden. Eine bekannte Schutzmaßnahme besteht darin, die Führungsvorrichtungen in derartigen Maschinen mit einer dünnen, hochohmigen Beschichtung zu versehen. Aus der PCT-WO 79/01123 ist eine Führungsvorrichtung bekannt, bei der ein Plastikträger mit einem Material aus der Gruppe der leitfähigen Metalle, Graphit oder einem leitfähigen Kohlenstoffmaterial beschichtet ist und die obere Abdeckung aus transparentem Material besteht.

Im Laufe der Zeit kann jedoch eine derartige Schicht ihre Schutzwirkung durch Abrieb oder Verdampfung verlieren. Außerdem ist eine unerwünschte Abhängigkeit von der umgebenden Luftfeuchte zu bemängeln. Ein nachlassen des Schutzes ist jedoch optisch nicht erkennbar, so daß eine einfache Überwachung nicht möglich ist. Darüberhinaus begünstigen die häufig in dem Antistatikum enthaltenen Halogene, Nitrate oder Sulfate eine Korrosion der metallischen Bausteinanschlüsse.

Aus der DE-OS 30 39 782 ist ein Stangenmagazin zur Aufnahme eines Stapels von Schaltelementen bekannt. Diese erhalten dadurch eine reibungsarme und somit eine tripoelektrische Aufladung vermindernde Führung, daß an wenigstens einer Innenwand ein kontinuierlich in Längsrichtung verlaufender Steg mit Dreickquerschnitt angebracht ist. Um jedoch jeden großflächigen Reibkontakt zwischen den Bausteinen und den Behälterwänden auszuschließen, ist besonders bei sog. DIL-Gehäusen (Dual in Line-Gehäusen) eine Vielzahl von derartigen Stegen erforderlich. Besondere Beachtung muß dabei den Anschlußbeinchen gelten, damit sie möglichst außer Kontakt mit den Behälterwänden bleiben. Trotz allem besteht bei einem derartigen Magazin weiterhin die Gefahr, daß die innen liegenden Halbleiterbausteine durch eine äußere Entladung durch die Behälterwände hindurch beschädigt werden können.

Der Erfindung lag die Aufgabe zugrunde, eine Führungsvorrichtung der eingangs genannten Art mit verbessserten Schutzeigenschaften anzugeben.

Diese Aufgabe wird erfindungsgemäß durch die Merkmale des kennzeichnenden Teils des Patentanspruchs 1 gelöst. Ausgestaltungen des Erfindungsgedankens sind in Unteransprüchen gekennzeichnet. Das hat den Vorteil, daß eine Führung der Bauelemente erreicht wird, die den Kontakt mit dem Behälter auf ein Minimum begrenzt, ohne das eine Vielzahl von einzelnen Gleitstegen ausgebildet werden muß. Die erfindungsgemäße Führung hält unzulässig hohe, externe Entladungsströme, beispielsweise verursacht von elektrostatisch aufgeladenen Personen, von den Bausteinen fern. Sie verhindert auch weitgehend eine tripoelektrische Aufladung. Wegen ihrer guten Gleiteigenschaften ist ein störungsfreies Bestücken und Entleeren der Führungsvorrichtung gewährleistet. Ferner hat die Erfindung den Vorteil, daß durch einen ständigen Ladungsausgleich zwischen den Bausteinanschlüssen der Aufbau einer größeren Potentialdifferenz verhindert wird. Eine Gefährdung der Bausteine durch Entladungen außerhalb des Behälters ist durch die Anordnung und die Formgebung der Entladestrecke ausgeschlossen. Neben der Minimierung der Berührungsfläche zwischen den aufladbaren Kunststoffgehäusen der Bauelemente und den Führungsteilen ermöglicht eine erfindungsgemäße Ausgestaltung der Führung auch eine Einstellung der Berührungswahrscheinlichkeit, des Kontaktdruckes und der Rutschhemmung. Der Gegenstand der Erfindung ermöglicht ferner eine gezielte, lokale Erhöhung der relativen Luftfeuchte in den kritischen Gleitbereichen von Bausteinen und Führung.

Im folgenden wird die Erfindung anhand eines in einer Figur dargestellten Ausführungsbeispiels weiter beschrieben.

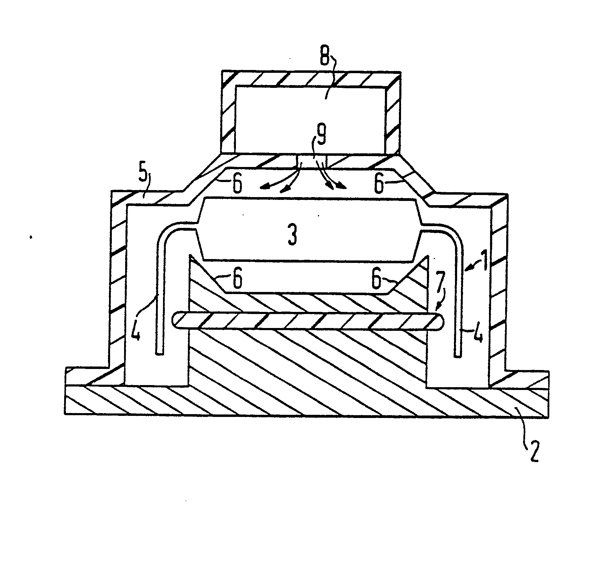

Die Figur zeigt einen Querschnitt durch eine rohrförmige Führungsvorrichtung, die ein Halbleiterbauelement 1 enthält. Sie ist dazu geeignet, eine Vielzahl derartiger Bauelemente aneinandergereiht in ihrem Innenraum aufzunehmen. Ein Zugriff dazu ist — aus der Figur nicht ersichtlich — über Öffnungen an beiden Enden der Führung möglich.

Das Halbleiterbauelement 1 weist ein Kunststoffgehäuse 3 und zwei Reihen von seitlich aus dem Gehäuse herausführenden und nach unten geneigten metallischen Beinchen 4 auf, über welche elektrische Verbindungen zu seinen im Inneren liegenden integrierten Schaltkreisen führen. Diese Bauform ist als Dual-in-Line-Gehäuse bekannt. Das Gehäuse 3 ist durch vier in Längsrichtung der Führung verlaufende Kanten gekennzeichnet.

Die Führungsvorrichtung besteht aus einem Unterteil 2, vorzugsweise aus Metall, und aus einem damit lösbar verbundenen Kunststoffoberteil 5. Zur Verringerung der Reibflächen zwischen dem Baustein 1 und der Führungsvorrichtung ist das Unterteil 2 und das Oberteil 5 mit in Längsrichtung verlaufenden Führungsflächen 6 versehen. Sie verhindern durch ihre Anordnung und ihre relative Lage zum Bauelement 1 daß ein flächiger Kontakt entstehen kann. Die Flächen 6 sind bezüglich der an die Gehäusekanten angrenzenden Gehäuseflächen so geneigt, daß lediglich ein auf die Gehäusekanten begrenzter Kontakt entstehen kann. In dem wiedergegebenen Beispiel sind das Unter- und Oberteil 2 zu diesem Zweck trapezförmig ausgebildet, wobei der Neigungswinkel der Führungsflächen 6 etwa 45° beträgt. Die Führungsflächen 6 müssen in ihrer Breite so ausgedehnt sein, daß der gewünschte Kantenkontakt auch eingehalten ist, wenn das Gehäuse 3 Quer- oder Kippbewegungen ausführt, die wegen des notwendigen Spiel nicht völlig auszuschließen sind.

Der durch die Führungsflächen 6 gegebenen Kanal kann auch durch V-förmige Ausbildung oder durch konkav gewölbte Flächen gebildet werden (nicht dargestellt). Durch die letztgenannte Maßnahme ist der Neigungswinkel, der durch einen Tangente an den Wölbungsradius bestimmt ist, nicht konstant.

Besonders vorteilhaft ist, wenn die Wände des Oberteils 5 in den entsprechenden Bereichen so verlaufen, daß ihre Innenseiten die Flächen 6 bilden. Im Bereich der Anschlußbeinchen 4 ist ein Ladungskollektor 7 angebracht, der einerseits als Führung und Abstandshalter und andererseits für den Ladungsausgleich zwischen den Anschlußreihen dient. Zu diesem Zweck ist er aus hochohmigem ($10^6$ bis $10^8$ Ohm) Material hergestellt.

Entlang der Führung ist auf dem Oberteil 5 ein Gaskanal 8 ausgebildet, von welchem aus über Öffnungen 9 ionisiertes Gas auf die Kontaktstellen zwischen Baustein 1 und Führungsflächen 6 geblasen wird. Über diesen Gaskanal 8 ist auch eine kurzzeitige lokale Erhöhung der relevanten Luftfeuchte in die Nähe des Taupunktes in den Gleitbereichen des Bausteins erreichbar. Bei der Gaszuleitung dienen die geneigten Führungsflächen 6 auch zur Führung des Gasstromes.

**Patentansprüche**

1. Führungsvorrichtung für Halbleiterbauelemente mit DIL-Gehäusen, bei welcher Vorkehrungen zum Schutz vor elektrostatischen Auf- und Entladungen getroffen sind, gekennzeichnet durch eine Ausgestaltung, die Kanten-Flächen-Berührungsstellen mit den Halbleiterbauelementen gewährleistet, wozu mindestens eine in Längsrichtung verlaufende Führungsfläche (6) vorgesehen ist, die bezüglich von an die Gehäusekanten angrenzenden Gehäuseflächen so geneigt ist, daß bei einem Kontakt zwischen der Führungsfläche (6) und dem Gehäuse (3) eine Flächenreibung ausgeschlossen und lediglich eine auf die Gehäusekante begrenzte Berührung möglich ist.

2. Führungsvorrichtung nach Anspruch 1, gekennzeichnet durch vier Führungsflächen (6).

3. Führungsvorrichtung nach Anspruch 2, dadurch gekennzeichnet, daß die Führungsflächen (6) eben sind und diagonal paarweise parallel verlaufen.

4. Führungsvorrichtung nach Anspruch 1 oder 2, dadurch gekennzeichnet, daß die Führungsfläche (6) konkav gewölbt ist, bwz. daß die Führungsflächen (6) konkav gewölbt sind.

5. Führungsvorrichtung nach einem der Ansprüche 1 bis 4, gekennzeichnet durch einen hochohmigen Ladungskollektor (7) zum Ausgleichen von Ladungen zwischen den beiden gegenüberliegenden Reihen von Anschlußbeinchen (4) des Halbleiterbauelements (1).

6. Führungsvorrichtung nach einem der Ansprüche 1 bis 5, dadurch gekennzeichnet, daß der Ladungskollektor (7) als Abstandshalter für die Anschlußbeinchen (4) des Halbleiterbauelements (1) bezüglich der Innenwand der Führungsvorrichtung dient.

7. Führungsvorrichtung nach einem der Ansprüche 1 bis 6, gekennzeichnet durch einen extern an der Führungsvorrichtung angeordneten Gaskanal (8), von welchem über Öffnungen (9) ionisiertes Gas oder Gas mit erhöhter Luftfeuchtigkeit in die Kontaktbereiche von Gehäuse (3) und Führungsvorrichtung geblasen wird.

**Claims**

1. Guiding device for semiconductor components with DIL housings, in which precautions have been taken to protect against electrostatic charges and discharges, characterized by a design which ensures edge-surfaces contact points with the semiconductor components, for which purpose at least one guide surface (6) extending in longitudinal direction is provided which is inclined, with respect to the housing surfaces adjacent to the housing edges, such that in the event of a contact between the guide surface (6) and the housing (3) a surface friction is excluded and only a contact limited to the housing edge is possible.

2. Guiding device according to Claim 1, characterized by four guide surfaces (6).

3. Guiding device according to Claim 2, characterized in that the guide surfaces (6) are plane and extend in diagonally parallel pairs.

4. Guiding device according to Claim 1 or 2, characterized in that the guide surface (6) is arched concavely, or in that the guide surfaces (6) are arched concavely.

5. Guiding device according to one of Claims 1 to 4, characterized by a high-impedance charge collector (7) for compensating charges between the two opposite rows of connecting leads (4) of the semiconductor component (1).

6. Guiding device according to one of Claims 1 to 5, characterized in that the charge connector (7) serves as a spacer for the connecting leads (4) of the semiconductor component (1) with respect to the inner wall of the guiding device.

7. Guiding device according to one of Claims 1 to 6, characterized by a gas channel (8) arranged externally on the guiding device, from which gas channel ionized gas or gas with increased air humidity is blown via openings (9) into the contact regions of housing (3) and guiding device.

**Revendications**

1. Dispositif de guidage pour des composants à semi-conducteurs comportant des boîtiers DIL, dans lequel des dispositions sont prises pour assurer une protection vis-à-vis de charges et de décharges électrostatiques, caractérisé par un agencement garantissant l'établissement de zones de contact arêtes-surfaces avec les composants à semi-conducteurs, auquel cas il est prévu à cet effet au moins une surface de guidage (6), qui s'étend dans la direction longitudinale et est inclinée par rapport à des surfaces du boîtier jouxtant les arêtes de ce dernier de sorte que, dans le cas d'un contact entre la surface de guidage (6) et le boîtier (3), un frottement de surface est exclu et que seul est possible un contact limité à l'arête du boîtier.

2. Dispositif de guidage suivant la revendication 1, caractérisé par quatre surfaces de guidage (6).

3. Dispositif de guidage suivant la revendication 2, caractérisé par le fait que les surfaces de guidage (6) sont planes et sont disposées parallèlement par couples en diagonale.

4. Dispositif de guidage suivant la revendication 1 ou 2, caractérisé par le fait que la surface de guidage (6) est cintrée avec une forme concave ou que les surfaces de guidage (6) sont cintrées avec une forme concave.

5. Dispositif de guidage suivant l'une des revendications 1 à 4, caractérisé par un collecteur de charges (7) de forte valeur ohmique, servant à compenser des charges entre les deux séries, disposées en vis-à-vis, de petites branches de raccordement (4) du composant à semi-conducteurs (1).

6. Dispositif de guidage suivant l'une des revendications 1 à 5, caractérisé par le fait que le collecteur de charges (7) est utilisé comme entretoise pour les petites branches de raccordement (4) du composant à semi-conducteurs (1) par rapport à la paroi intérieure du dispositif de guidage.

7. Dispositif de guidage suivant l'une des revendications 1 à 6, caractérisé par un canal à gaz (8), qui est disposé à l'extérieur contre le dispositif de guidage et à partir duquel un gaz ionisé ou un gaz possédant une humidité accrue est introduit par soufflage, par l'intermédiaire d'ouvertures (9), dans les zones de contact du boîtier (3) et du dispositif de guidage.